# EUROPÄISCHE PATENTSCHRIFT

(11) **EP 3 314 035 B1**
(45) Veröffentlichungstag und Bekanntmachung des Hinweises auf die Patenterteilung: **24.07.2019**
(21) Anmeldenummer: 16736008.0
(22) Anmeldetag: 20.06.2016
(51) Int. Cl.: C23C 14/56, C23C 14/50, C23C 16/54, H01L 21/677, C23C 16/26, B65H 20/18, B65H 20/00, C23C 16/458

(54) **FÖRDEREINRICHTUNG FÜR EIN SUBSTRAT**
CONVEYOR DEVICE FOR A SUBSTRATE
DISPOSITIF DE TRANSPORT POUR UN SUBSTRAT

(30) Priorität: 23.06.2015 DE 102015110087
(43) Veröffentlichungstag der Anmeldung: 02.05.2018
(73) Patentinhaber: Aixtron SE, 52134 Herzogenrath (DE)
(72) Erfinder: RUPESINGHE, Nalin Lalith, Cambridge Cambridgeshire CB4 3NB (GB); GONCALVES, Goncalo Pedro, Cambridge Cambridgeshire CB5 8HJ (GB); TEO, Kenneth B. K., Cambridge Cambridgeshire CB23 5BH (GB)
(74) Vertreter: Grundmann, Dirk
(86) Internationale Anmeldenummer: PCT/EP2016/064117
(87) Internationale Veröffentlichungsnummer: WO 2016/207088

(56) Entgegenhaltungen:
- WO-A2-2009/024460
- US-A1- 2013 052 413

## Beschreibung

### Gebiet der Technik

Die Erfindung betrifft eine Vorrichtung zum Transport eines bandförmigen Substrates durch einen Reaktor, wobei das Substrat von Transportelementen gehalten ist, die in einer Transportrichtung von einem Antriebsaggregat verlagerbar sind.

### Stand der Technik

Die DE 32 14 999 A1 beschreibt eine Vorrichtung zum kontinuierlichen Transport eines Werkstücks durch einen Ofen, bei dem das Werkstück im Taktverfahren abwechselnd von einem von insgesamt zwei Hubbalken horizontal transportiert wird.

Die DE 10 2013 108 056 A1 beschreibt eine Substratförderungsanlage zur horizontalen Förderung eines Endlossubstrats, wobei an den Rändern des Substrates Rollstücke angreifen, die entlang von Schienen geführt werden.

Die WO 2013/028496 A1 beschreibt eine Fördervorrichtung für ein Endlossubstrat, bei dem die Ränder des Substrates zwischen zwei bewegungsangetriebenen Transportbändern eingeklemmt sind.

Die US 2013/052413 A1 und WO 2009/024460 A2 beschreiben Vorrichtungen zum Transport von bandförmigen Substarten durch einen Reaktor.

Das Abscheiden von Graphene oder Kohlenstoffnanoröhrchen oder andere Nanopartikel aus Kohlenstoff erfordert eine Prozesskammer, in der ein Substrat auf eine Prozesstemperatur, die oberhalb von 1000°C liegt, aufgeheizt wird. In dem Reaktor, in dessen Prozesskammer der Abscheideprozess stattfindet, wird eine Oberfläche eines bandförmigen Endlossubstrates beschichtet.

Das Substrat wird auf einer Seite des Reaktors von einem ersten Wickel abgerollt und auf der anderen Seite des Reaktors auf einen zweiten Wickel wieder aufgerollt. Bei dem Substrat kann es sich um einen Metallstreifen handeln, dessen Festigkeit bei den Prozesstemperaturen derart sinkt, dass zusätzliche Hilfsmittel erforderlich sind, um das Substrat während seines Transportes durch die Prozesskammer des Reaktors zu stabilisieren.

### Zusammenfassung der Erfindung

Der Erfindung liegt die Aufgabe zugrunde, eine Transportvorrichtung für ein bandförmiges Substrat anzugeben, die das Substrat mit einer geringen mechanischen Belastung durch den Reaktor hindurch fördert.

Gelöst wird die Aufgabe durch die in den Ansprüchen angegebene Erfindung, wobei die Unteransprüche vorteilhafte Weiterbildungen des Hauptanspruchs darstellen.

Die Aufgabe wird zunächst und im Wesentlichen dadurch gelöst, dass die Transportmittel erste und zweite Transportbalken aufweisen. Die Transportbalken werden erfindungsgemäß hin und her bewegt. Während sich mindestens ein erster Transportbalken in Transportrichtung verlagert, wird mindestens ein zweiter Transportbalken in einer Rückwärtsbewegung entgegengesetzt zur Transportrichtung zurückverlagert. Es ist eine Steuerungseinrichtung und es sind Stellantriebe vorgesehen, mit denen die Transportbalken derart verlagert werden können, dass nur der zumindest eine sich in Vorwärtsrichtung verlagernde Transportbalken am Substrat angreift, während der sich zurückverlagernde Transportbalken nicht am Substrat angreift. In einer ersten Variante können die Transportbalken derart bewegungsangetrieben werden, dass sich der erste Transportbalken in der einen Richtung bewegt, während sich der zweite Transportbalken in Gegenrichtung bewegt. Die Transportbalken können zum selben Zeitpunkt ihre Bewegung umkehren, wobei im Bewegungsumkehrzeitpunkt ein Wechsel zwischen den jeweils am Substrat angreifenden Transportbalken erfolgt. Der Antrieb erfolgt dann schrittweise ähnlich einem Schrittschaltgetriebe. Es ist aber auch vorgesehen, dass die Steuerung die Antriebs- und Stelleinrichtungen zur Verlagerung der Transportbalken derart ansteuert, dass ein Wechsel des Angriffs am Substrat während der Bewegung des Substrates erfolgt. Die Übergabe der Transportfunktion erfolgt dann zeitlich vor dem Bewegungsumkehrzeitpunkt der Transportbalken. Während sich beispielsweise die ersten Transportbalken langsam in Transportrichtung verlagern, werden die zweiten Transportbalken, die nicht am Substrat angreifen, schnell in Rückwärtsrichtung zurückverlagert. Kurz bevor die ersten Transportbalken ihre Endstellung erreichen, werden die zweiten Transportbalken auf die Transportgeschwindigkeit beschleunigt, so dass erste und zweite Transportbalken mit derselben Geschwindigkeit verlagert werden. Während dieser Parallelbewegung der beiden Transportbalken erfolgt der Wechsel im Angriff an dem Substrat von den ersten Transportbalken zu den zweiten Transportbalken. Während dann die zweiten Transportbalken das Substrat mit der Transportgeschwindigkeit weiter transportieren, werden die ersten Transportbalken mit erhöhter Geschwindigkeit zurückverlagert, um dann in analoger Weise auf die Transportgeschwindigkeit beschleunigt zu werden, wenn sich die zweiten Transportbalken ihrer Endposition annähern, um dann wiederum in einer Phase, in der alle Transportbalken sich in Transportrichtung mit Transportgeschwindigkeit verlagern, den Transport des Substrates zu übernehmen. Die Transportbalken greifen bevorzugt an den beiden Längsrändern des Substrates an. Die Transportbalken können aber auch beispielsweise in der Mitte oder an anderen Stellen das Substrat unterstützen. Gemäß einem ersten Aspekt der Erfindung bilden randseitige Transportbalken Klemmflanken aus, die von Klemmflächen gebildet sein können. Es sind insbesondere obere und untere Transportbalken vorgesehen, die aufeinander zu weisende Klemmflanken aufweisen. Durch eine Aufeinander-Zu-Bewegung der oberen und unteren Transportbalken können die Klemmflanken in eine klemmende Anlagestellung gegen den Rand des Substrates gebracht werden. Hierdurch wird eine kraftschlüssige Verbindung zwischen Substrat und Transportmittel erreicht, so dass die am Substrat angreifenden Transportmittel das Substrat in Transportrichtung fördern, während nicht am Substrat angreifende Transportmittel, also Transportbalken, die voneinander beabstandet sind, in Gegenrichtung zur Transportrichtung zurückverlagert werden. Es können aber auch Transportbalken vorgesehen sein, die das Substrat lediglich von unten her unterstützen. Eine Unterstützung kann auch zwischen den Rändern des Substrates erfolgen. Es sind bevorzugt Transportschlitten vorgesehen, mit denen die Transportbalken gehalten werden. Die Transportschlitten können gegenüber einem ortsfesten Träger horizontal verlagert werden. Hierzu dienen Horizontalantriebe, die von der Steuerungseinrichtung angesteuert werden. Bei den Horizontalantrieben kann es sich um Zahnräder handeln, die in eine ortsfeste Zahnstange des Trägers eingreifen und die von einem Motor angetrieben werden, der am Transportschlitten sitzt. Es ist aber auch möglich, die Zahnstange fest mit dem Transportschlitten zu verbinden und den Motor bzw. das Zahnradgetriebe dem Träger zuzuordnen. Auch hydraulische oder pneumatische Antriebe sind vorgesehen. Die Transportschlitten vollziehen bei der Förderbewegung des Substrates jeweils eine Hin- und Herbewegung. Es ist insbesondere vorgesehen, dass auf jeder Seite des Reaktors, also auf der Seite, in der das Substrat in den Reaktor einläuft und auf der anderen Seite, auf der das Substrat aus dem Reaktor herausläuft, jeweils zwei Transportschlitten angeordnet sind. Es ist vorgesehen, dass die ersten und die zweiten Transportbalken jeweils in Horizontalrichtung starr mit ihren Enden mit einem zugeordneten Transportschlitten verbunden sind. Die Transportbalken durchragen dabei den Reaktor und dessen Prozesskammer, so dass jeder Transportbalken mit einem substrateinlaufseitigen Transportschlitten und einem substratauslaufseitigen Transportschlitten verbunden ist. Bevorzugt besitzen die Transportbalken voneinander verschiedene Längen, so kann der mindestens eine erste Transportbalken kürzer sein als der mindestens eine zweite Transportbalken. Während die auf der einen Seite des Reaktors angeordneten Transportschlitten eine Aufeinander-Zu-Bewegung machen, machen die auf der anderen Seite des Reaktors angeordneten Transportschlitten eine Voneinander-Weg-Bewegung. Dabei wird das Substrat von einer zulaufseitigen Vorratsrolle abgewickelt und auf einer auslaufseitigen Rolle aufgewickelt. Innerhalb des Reaktors 20, also etwa in der Mitte der Transportbalken, herrscht eine Temperatur von über 1000°C. Die Transportbalken besitzen deshalb insbesondere in diesem mittleren Bereich hitzebeständige Eigenschaften. Sie können aus Quarz, Keramik oder aus Edelstahl bestehen. Sie können aber auch aus mehreren verschiedenen Werkstoffen zusammengesetzt werden. An den beiden Enden, dort wo sich die Transportschlitten befinden, beträgt die Temperatur weniger als 100°C, bevorzugt weniger als 50°C. In Erstreckungsrichtung der Transportbalken, also in Substratförderrichtung, bildet sich somit ein Temperaturgradient aus. Es kann ferner von Vorteil sein, wenn mehrere Transportbalkenanordnungen in Transportrichtungen hintereinander angeordnet sind. Es ist dann sogar möglich, dass zwei voneinander verschiedene Transportbalkenanordnungen oder Paare von Transportbalkenanordnungen in der Mitte der Prozesskammer aneinander angrenzen, so dass eine aus mindestens zwei Transportbalken bestehende Substrattransportvorrichtung das Substrat bis in die Mitte der Prozesskammer fördert und eine zweite ebenfalls mindestens zwei Transportbalken aufweisende Substrattransportvorrichtung das Substrat von der Mitte aus weiter durch die Prozesskammer hindurch fördert. Ferner kann vorgesehen sein, dass die ersten und die zweiten Transportbalken jeweils gleich lang sind.

Ein zweiter Aspekt der Erfindung betrifft eine Vorrichtung zum Transport eines bandförmigen Substrates durch einen Reaktor, wobei das Substrat von Transportelementen gehalten ist, die in einer Transportrichtung von einem Antriebsaggregat verlagerbar sind, wobei die Transportmittel erste Transportbalken und zweite Transportbalken aufweisen, die in einem zeitlichen Wechsel am Substrat angreifen, wobei die jeweils am Substrat angreifenden Transportbalken in Transportrichtung und die jeweils nicht am Substrat angreifenden Transportbalken in einer Rückwärtsrichtung entgegengesetzt zur Transportrichtung bewegt werden. Wesentlich sind paarweise in Transportrichtung jeweils vor und hinter dem Reaktor angeordnete Transportschlitten zur Verlagerung der Transportbalken in der Transportrichtung.

### Kurze Beschreibung der Zeichnungen

Im Folgenden wird die Erfindung anhand eines Ausführungsbeispiels näher erläutert. Es zeigen:

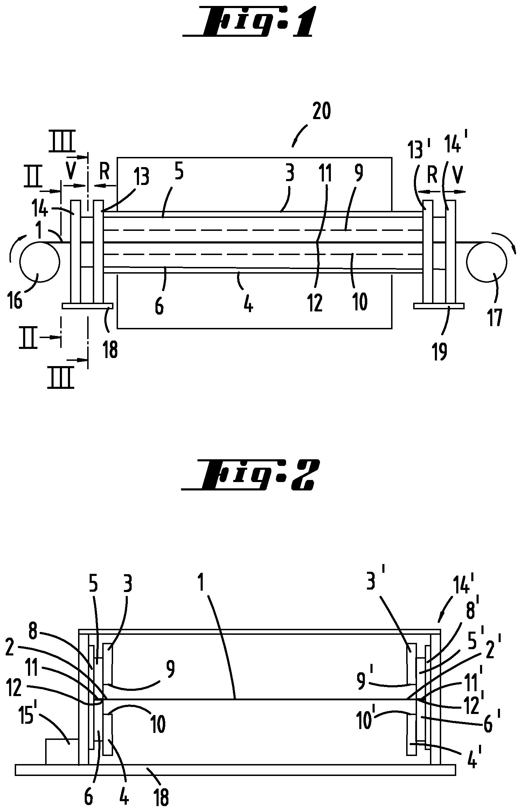

- Fig. 1: schematisch in einer Seitenansicht eine Transportfördereinrichtung, mit der ein streifenförmiges, flexibles Substrat 1 von einer ersten Rolle 16 abgewickelt und durch die Prozesskammer eines Reaktors 20 gefördert und auf einer zweiten Rolle 17 aufgewickelt wird, wobei eine Bewegungsphase dargestellt ist, in der sich eine erste Transportbalkenanordnung 13, 13', 3, 4 in einer Rückwärtsbewegung R befindet und eine zweite Transportbalkenanordnung 14, 14', 5, 6 in einer Vorwärtsbewegung V angetrieben wird, wobei die Transportbalken 5, 6 das Substrat 1 zwischen zwei Klemmflächen 11, 12 klemmend haltern;
- Fig. 2: den Schnitt gemäß der Linie II - II, wobei in Transportrichtung V hinter dem Transportschlitten 14 der zweiten Transportbalkenanordnung liegende Bauteile ausgeblendet sind;
- Fig. 3: einen Schnitt gemäß der Linie III - III in Figur 1, wobei die in Transportrichtung V hinter dem Transportschlitten 13 der ersten Transportbalkenanordnung liegenden Bauteile ausgeblendet sind; anderen
- Fig. 4: eine Darstellung gemäß Figur 1, jedoch in einer Betriebsstellung, in der die erste Transportbalkenanordnung 13, 3, 4 mit Klemmflächen 9, 10 am Substrat 1 angreift und in Vorwärtsrichtung V verlagert wird und die zweite Transportbalkenanordnung 14, 5, 6 nicht am Substrat 1 angreift und in Rückwärtsrichtung R verlagert wird;
- Fig. 5: einen Schnitt gemäß der Linie V - V in Figur 4, wobei auch hier die in Förderrichtung V hinter dem Transportschlitten 14 angeordneten Bauteile ausgeblendet sind;
- Fig. 6: einen Schnitt gemäß der Linie VI - VI in Figur 4, wobei auch hier die in Förderrichtung hinter dem Transportschlitten 13 angeordneten Elemente der Vorrichtung ausgeblendet sind;
- Fig. 7: eine ähnliche Darstellung gemäß der Figuren 1 und 4 in einem ersten Bewegungsumkehrpunkt der ersten Transportbalkenanordnung 13, 3, 4 und der zweiten Transportbalkenanordnung 14, 5, 6;
- Fig. 8: eine Darstellung gemäß Fig. 7, jedoch im zweiten Bewegungsumkehrpunkt der beiden Transportbalkenanordnungen;
- Fig. 9: ein Weg-Zeitdiagramm zur Verdeutlichung der Bewegung und der Wechselzeiten w1 bis w6 bei einem gleichmäßigen Bewegungsantrieb des Substrates 1;
- Fig. 10: die Draufsicht auf eine zwei Transportbalkenanordnungen, 3, 4, 13; 5, 6, 14 aufweisende Substratfördereinrichtung eines zweiten Ausführungsbeispiels.

### Beschreibung der Ausführungsformen

In den Figuren ist eine Fördereinrichtung in Kombination mit einem CVD-Reaktor 20 lediglich schematisch dargestellt. Es handelt sich um einen Reaktor 20 zum Abscheiden von Kohlenstoffnanopartikeln, Graphen, Kohlenstoffnanoröhrchen oder dergleichen, wie er im Stand der Technik und in der einschlägigen Literatur beschrieben ist. Insbesondere gasförmige Ausgangsstoffe werden in eine Prozesskammer des Reaktors 20 eingebracht. Durch die Prozesskammer des Reaktors 20 wird ein insbesondere metallisches Endlossubstrat 1 gefördert. Das Substrat bzw. die Prozesskammer des Reaktors 20 werden auf eine Prozesstemperatur über 1000°C aufgeheizt. Bei dieser Temperatur scheiden sich die Nanopartikel auf der Oberfläche des Substrates 1 ab. Die Breite des Substrates kann etwa 300 Millimeter betragen. Ein derartig schmales Substrat braucht lediglich am an den voneinander weg weisenden Rändern gefasst zu werden. Eine Unterstützung im mittleren Bereich ist hier nicht erforderlich, wenngleich aber auch möglich.

Es ist eine erste Transportbalkenanordnung 13, 3, 4 vorgesehen und eine zweite Transportbalkenanordnung 14, 5, 6, die im zeitlichen Wechsel mittels Klemmflächen 9, 9', 10, 10' bzw. 11, 11', 12, 12' am Rand 2, 2' des Substrates 1 angreifen, um das von einer ersten Rolle 16 abgewickelte Substrat 1 durch die Prozesskammer des Reaktors 20 hindurch zu fördern, welches Substrat 1 dann anschließend auf einer zweiten Rolle 17 wieder aufgewickelt wird. Das Substrat 1 wird dabei in einer Vorwärtsrichtung V transportiert.

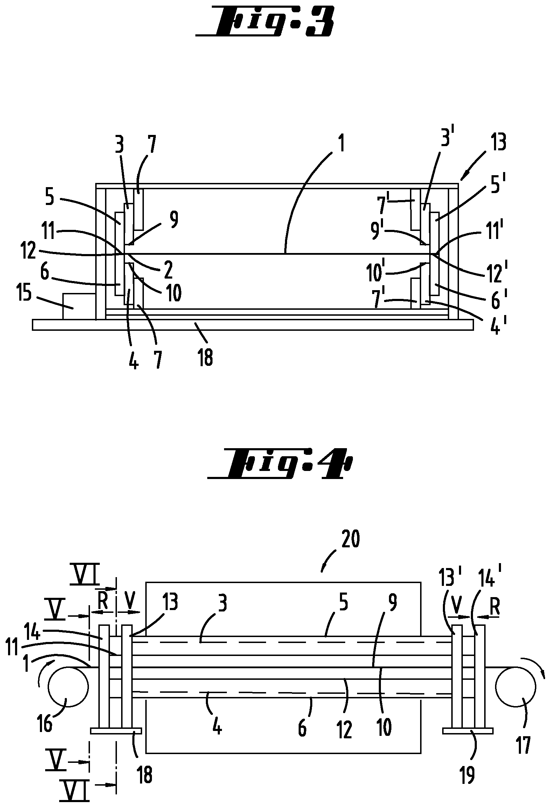

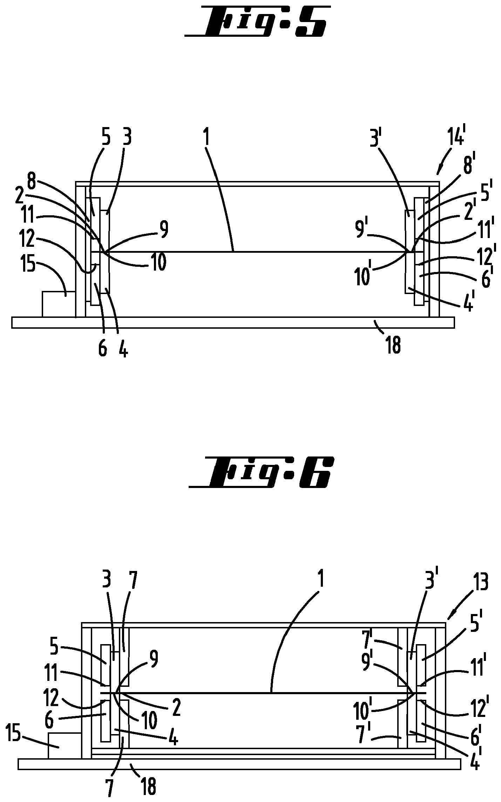

Die erste Transportbalkenanordnung besitzt einen ersten Transportschlitten 13, der einen torförmigen Rahmen aufweist, an dem (siehe Figur 3) Vertikalantriebe 7, 7' befestigt sind. Die Vertikalantriebe 7, 7' sind nahe des Randes des durch die Toröffnung des Transportschlittens 13 geförderten Substrates 1 angeordnet. Mit den Vertikalantrieben 7, 7' können jeweils am Rand 2, 2' des Substrates 1 angeordnete obere Transportbalken 3, 3' herauf und herunter verlagert werden und untere Transportbalken 4, 4' herauf und herunter verlagert werden. Die ersten Transportbalken 3, 3', 4, 4' bilden innere Transportbalken aus. Sie können von der in der Figur 3 dargestellten Abstandsstellung in die in der Figur 6 dargestellte Klemmstellung gebracht werden. In der Klemmstellung liegt der Rand 2, 2' des Substrates 1 jeweils zwischen den Klemmflächen 9, 9'; 10, 10' des oberen Transportbalkens 3, 3' und des unteren Transportbalkens 4, 4'.

Sowohl auf der einlaufseitigen Seite des Reaktors 20 als auch auf der auslaufseitigen Seite des Reaktors 20 befindet sich jeweils ein Transportschlitten 13, 13', der jeweils ein Ende der ersten Transportbalkens 3, 3', 4, 4' hält. Die beiden ersten Transportschlitten 13, 13' können mittels eines Horizontalantriebs 15 in Horizontalrichtung gegenüber einem ortsfesten Träger 18 verlagert werden. Erfindungsgemäß ist eine Hin- und Herverlagerung vorgesehen.

Es ist eine zweite Transportbalkenanordnung 14, 5, 6 vorgesehen. Auch diese Transportbalkenanordnung besitzt zwei Transportschlitten 14, 14', wobei jeweils ein Transportschlitten 14 auf der substrateinlaufenden Seite des Reaktors 20 und ein Transportschlitten 14' auf der substratauslaufenden Seite des Reaktors 20 angeordnet ist. Wie bei der ersten Transportbalkenanordnung besitzt auch die zweite Transportbalkenanordnung insgesamt vier Transportbalken, 5, 5', 6, 6', wobei es sich bei diesen Transportbalken um äußere Transportbalken handelt, die ebenfalls am Rand 2, 2' des Substrates angreifen können. Die mit ihren Enden jeweils an einem Transportschlitten 14, 14' befestigten zweiten Transportbalken 5, 5', 6, 6' sind länger als die ersten Transportbalken 3, 3', 4, 4'. Die Transportschlitten 14, 14' besitzen einen Horizontalantrieb 15, 15', um die zweite Transportbalkenanordnung in einer Hin- und Herrichtung anzutreiben.

Der torförmige zweite Transportschlitten 14, 14' trägt zweite Vertikalantriebe 8, mit denen die zweiten Transportbalken 5, 5', 6, 6' von der in der Figur 2 dargestellten Klemmstellung in die in der Figur 5 dargestellte Beabstandungsstellung zum Rand 2 des Substrates 1 gebracht werden können. Hierzu werden obere Transportbalken 5, 5' nach oben und untere Transportbalken 6, 6' nach unten verlagert. Dabei entfernt sich jeweils eine obere Klemmfläche 11 eines oberen Transportbalkens 5, 5' von einer unteren Klemmfläche 11, 11' eines unteren Transportbalkens 6, 6'.

Bei den Vertikalantrieben 8, 8', 7, 7' kann es sich um Zahnstangenantriebe, Spindelantriebe, Hydraulik- oder Pneumatikkolbenzylinderantriebe handeln. Bei den Horizontalantrieben 15, 15' kann es sich um Zahnradgetriebe handeln, bei denen beispielsweise ein Zahnrad in eine Zahnstange eingreift. Bei dem Horizontalantrieb werden drehmomentbegrenzte Servomotoren verwendet. Die Vertikalbewegung kann über einen drehbaren Exzenterarm vorgenommen werden.

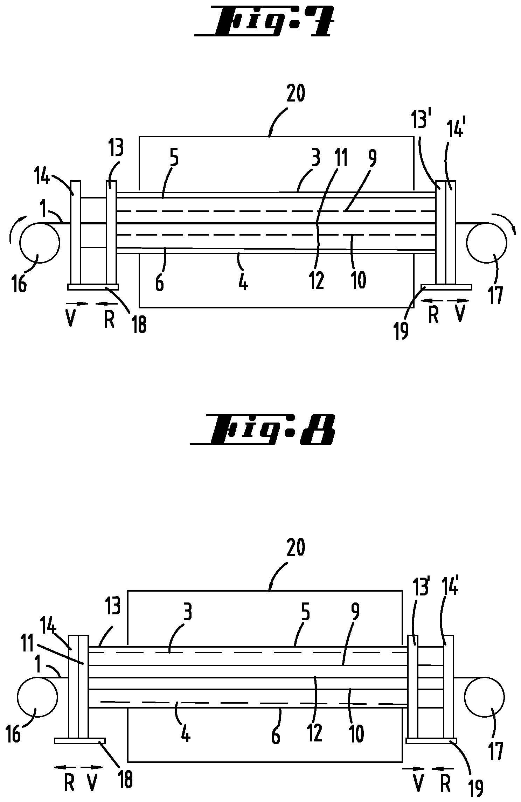

Die Vorrichtung kann im Schrittverfahren betrieben werden. Bei diesem Verfahren verlagern sich die beiden Klemmbalkenanordnungen jeweils in entgegengesetzter Richtung, wobei die Klemmbalkenanordnung, die sich in Vorwärtsrichtung V bewegt, das Substrat 1 fördert. Hierzu klemmen die diesbezüglichen Klemmflächen 10, 10', 11, 11', 12, 12' den Rand 2, 2' des Substrates 1 zwischen sich ein. Die in Rückwärtsrichtung R sich verlagernde Transportbalkenanordnung besitzt hingegen Klemmflächen 9, 12, die vom Rand 2, 2' des Substrates 1 beabstandet sind. Die beiden Transportbalkenanordnungen verlagern sich dabei zwischen den in den Figuren 7 und 8 dargestellten Bewegungsumkehrpositionen, die gleichzeitig erreicht werden.

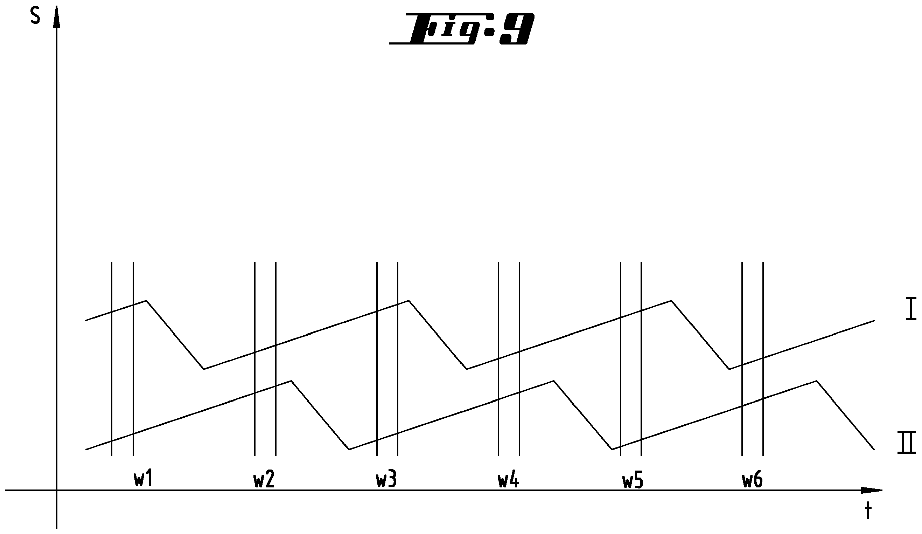

Es ist aber auch möglich, das Substrat 1 mit einer gleichbleibenden, kontinuierlichen Bewegung zu fördern. Das diesbezügliche Bewegungsdiagramm zeigt die Figur 9. Dort ist die Bewegungsstrecke S der beiden Transportbalkenanordnungen I, II gegenüber der Zeit t abgetragen.

Mit w1 bis w6 sind die Zeitabschnitte bezeichnet, in denen ein Wechsel der Funktion der jeweiligen Klemmbalkenanordnung als substratfördernde Anordnung oder zurückverlagerte Anordnung wechselt. Während w1 wird die Klemmung des Substrates 1 durch die Klemmelemente der ersten Transportbalkenanordnung 1 gelöst und die Klemmelemente der zweiten Transportbalkenanordnung in eine Klemmstellung gebracht, so dass die zweite Transportbalkenanordnung die Förderung des Substrates 1 übernimmt. Die erste Transportbalkenanordnung wird dann im Eilgang zurückgefahren und übernimmt zu w2 die Förderung des Substrates. Bei w3 findet wiederum ein Wechsel der Förderung von der ersten Transportbalkenanordnung zu der zweiten Transportbalkenanordnung statt. Mit w4, w5, w6 sind analoge Wechsel bezeichnet. Die Figur 9 verdeutlicht, dass zum Zeitpunkt der Klemmwechsel w1 bis w6 beide Transportbalkenanordnungen I, II dieselbe Geschwindigkeit besitzen.

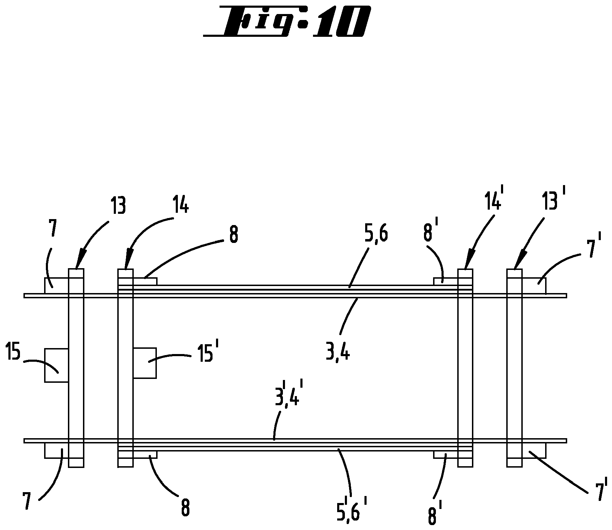

Die Figur 10 zeigt in der Draufsicht eine Substratfördereinrichtung. Die Transportfördereinrichtung besitzt äußere Transportbalken 5, 6 bzw. 5', 6', die mit ihren Längsenden jeweils an einem Transportschlitten 14, 14' befestigt sind. Am Transportschlitten 14, 14' befinden sich Vertikalantriebe 8, 8', um die Transportbalken 5, 5', 6, 6' in der zuvor beschriebenen Weise in Vertikalrichtung zu verlagern. Auch hier handelt es sich bei den Transportschlitten 14, 14' um torförmige Objekte.

Die beiden innen liegenden Transportbalken 3, 4, bzw. 3', 4' sind länger ausgebildet als die äußeren Transportbalken 5, 6, 5', 6'. Sie sind mit ihren Längsenden jeweils an Transportschlitten 13, 13' befestigt. Auch die Transportschlitten 13,13' sind torförmige Objekte. Bei ihrer Bewegung können die Transportschlitten 13 bis in Anlage an die Transportschlitten 14 bzw. die Transportschlitten 13' bis in berührender Anlage an die Transportschlitten 14' verlagert werden. Die Vertikalantriebe 7, 7' bzw. 8, 8' sind deshalb an den Vertikalholmen der torförmigen Transportschlitten 13, 13', 14, 14' auf voneinander weg weisenden Seiten angeordnet.

Die vorstehenden Ausführungen dienen der Erläuterung der von der Offenbarung insgesamt erfassten Erfindungen, die den Stand der Technik zumindest durch die folgenden Merkmalskombinationen jeweils auch eigenständig weiterbilden, nämlich:

Eine Vorrichtung, dadurch gekennzeichnet ist, dass die Transportmittel erste Transportbalken 3, 3', 4, 4' und zweite Transportbalken 5, 5', 6, 6' aufweisen, die in einem zeitlichen Wechsel am Substrat 1 angreifen, wobei die jeweils am Substrat 1 angreifenden Transportbalken in Transportrichtung V und die jeweils nicht am Substrat angreifenden Transportbalken in einer Rückwärtsrichtung R entgegengesetzt zur Transportrichtung V bewegt werden.

Eine Vorrichtung, die gekennzeichnet ist durch paarweise in Transportrichtung V jeweils vor und hinter den Reaktor (20) angeordnete Transportschlitten 13, 13', 14, 14'.

Eine Vorrichtung, die dadurch gekennzeichnet ist, dass die Transportschlitten 13, 13', 14, 14' derart angeordnet und mit Transportbalken 3, 3' bis 6, 6' miteinander verbunden sind, dass sich während einer Bewegungsphase, in der sich die auf der einen Seite des Reaktors 20 angeordneten Transportschlitten 13, 14 aufeinander zu bewegen, sich die auf der anderen Seite des Reaktors 20 angeordneten Transportschlitten 13', 14' voneinander weg bewegen, wobei die ersten Transportbalken 3, 3', 4, 4' kürzer sind als die zweiten Transportbalken 5, 5', 6, 6'

Eine Vorrichtung, dadurch gekennzeichnet ist, dass die Transportbalken 3, 3', 4, 4', 5, 5', 6, 6' Klemmflanken 9, 9', 10, 10', 11, 11', 12, 12' aufweisen, um insbesondere den Rand 2, 2' des Substrates 1 klemmend zwischen zwei Klemmflanken zu halten.

Eine Vorrichtung, dadurch gekennzeichnet ist, dass die Transportbalken untere Transportbalken 4, 4', 6, 6' und obere Transportbalken 3, 3', 5, 5' aufweisen, wobei das Substrat 1 von den jeweils in Transportrichtung V verlagerten Transportbalken durch eine Zwischenlage zwischen zwei Klemmflächen 9, 9', 10, 10', 11, 11', 12, 12' eines oberen und eines unteren Transportbalkens gehalten ist.

Eine Vorrichtung, dadurch gekennzeichnet ist, dass die Transportbalken 3, 3', 4, 4', 5, 5', 6, 6' mittels Vertikalantrieben 7, 7', 8, 8' in einer Richtung quer zur Flächennormalen des Substrates 1 von einer Anlagestellung am Substrat 1 in eine Abstandsstellung zum Substrat 1 bringbar ist.

Eine Vorrichtung, die gekennzeichnet ist durch Horizontalantriebe 15, 15' zur Horizontalverlagerung der Transportschlitten 13, 13', 14, 14' und Vertikalantriebe 7, 7', 8, 8' zur Verlagerung der Transportbalken 3, 3', 4, 4', 5, 5', 6, 6' zwischen einer Anlagestellung am Substrat 1 und einer Abstandsstellung zum Substrat 1, wobei die Antriebe 15, 15'; 7, 7', 8, 8' derart gesteuert werden, dass die Verlagerung der Transportbalken in den Bewegungsumkehrpunkten der Transportschlitten erfolgt oder während einer Bewegung aller Transportschlitten 13, 13', 14, 14' in der Transportrichtung V.

Eine Vorrichtung, die dadurch gekennzeichnet ist, dass der Reaktor 20 ein CVD-Reaktor ist.

Eine Vorrichtung, die dadurch gekennzeichnet ist, dass mit dem Reaktor 20 Kohlenstoffnanopartikel, Graphen oder Kohlenstoffnanoröhrchen auf dem Substrat 1, insbesondere bei einer Temperatur > 1000°C, abgeschieden werden.

**Liste der Bezugszeichen**

| | | | |
|---|---|---|---|
| 1 | Substrat | 15' | Horizontalantrieb |
| 2 | Rand | 16 | Wickel |
| 2' | Rand | 17 | Wickel |
| 3 | Transportbalken | 18 | Träger |
| 3' | Transportbalken | 19 | Träger |
| 4 | Transportbalken | 20 | Reaktor |
| 4' | Transportbalken | | |
| 5 | Transportbalken | R | Rückwärtsrichtung |
| 5' | Transportbalken | V | Transportrichtung |
| 6 | Transportbalken | | |
| 6' | Transportbalken | | |
| 7 | Vertikalantrieb | | |
| 7' | Vertikalantrieb | | |
| 8 | Vertikalantrieb | | |
| 8' | Vertikalantrieb | | |
| 9 | Klemmfläche | | |
| 9' | Klemmfläche | | |
| 10 | Klemmfläche | | |
| 10' | Klemmfläche | | |
| 11 | Klemmfläche | | |
| 11' | Klemmfläche | | |
| 12 | Klemmfläche | | |
| 12' | Klemmfläche | | |
| 13 | Transportschlitten | | |
| 13' | Transportschlitten | | |
| 14 | Transportschlitten | | |
| 14' | Transportschlitten | | |
| 15 | Horizontalantrieb | | |

## Patentansprüche

1. Vorrichtung zum Transport eines bandförmigen Substrates (1) durch einen Reaktor (20), wobei das Substrat (1) von Transportelementen (3, 3', 4, 4', 5, 5', 6, 6') gehalten ist, die in einer Transportrichtung (V) von einem Antriebsaggregat (15, 15') verlagerbar sind, wobei die Transportmittel erste Transportbalken (3, 3', 4, 4') und zweite Transportbalken (5, 5', 6, 6') aufweisen, die in einem zeitlichen Wechsel am Substrat (1) angreifen, wobei die jeweils am Substrat (1) angreifenden Transportbalken in Transportrichtung (V) und die jeweils nicht am Substrat angreifenden Transportbalken in einer Rückwärtsrichtung (R) entgegengesetzt zur Transportrichtung (V) bewegt werden, **dadurch gekennzeichnet, dass** die Transportbalken (3, 3', 4, 4', 5, 5', 6, 6') Klemmflanken (9, 9', 10, 10', 11, 11', 12, 12') aufweisen, um das Substrates (1) klemmend zwischen zwei Klemmflanken zu halten.

2. Vorrichtung nach Anspruch 1, **gekennzeichnet durch** paarweise in Transportrichtung (V) jeweils vor und hinter den Reaktor (20) angeordnete Transportschlitten (13, 13', 14, 14').

3. Vorrichtung nach einem der vorangehenden Ansprüche, **dadurch gekennzeichnet, dass** die Klemmflanken (9, 9', 10, 10', 11, 11', 12, 12') den Rand (2, 2') des Substrates (1) klemmend halten.

4. Vorrichtung nach einem der vorangehenden Ansprüche, **dadurch gekennzeichnet, dass** die Transportschlitten (13, 13', 14, 14') derart angeordnet und mit Transportbalken (3, 3') bis (6, 6') miteinander verbunden sind, dass sich während einer Bewegungsphase, in der sich die auf der einen Seite des Reaktors (20) angeordneten Transportschlitten (13, 14) aufeinander zu bewegen, sich die auf der anderen Seite des Reaktors (20) angeordneten Transportschlitten (13', 14') voneinander weg bewegen, wobei die ersten Transportbalken (3, 3', 4, 4') kürzer sind als die zweiten Transportbalken (5, 5', 6, 6').

5. Vorrichtung nach einem der vorangehenden Ansprüche, **dadurch gekennzeichnet, dass** die Transportbalken untere Transportbalken (4, 4', 6, 6') und obere Transportbalken (3, 3', 5, 5') aufweisen, wobei das Substrat (1) von den jeweils in Transportrichtung (V) verlagerten Transportbalken durch eine Zwischenlage zwischen zwei Klemmflächen (9, 9', 10, 10', 11, 11', 12, 12') eines oberen und eines unteren Transportbalkens gehalten ist.

6. Vorrichtung nach einem der vorangehenden Ansprüche, **dadurch gekennzeichnet, dass** die Transportbalken (3, 3', 4, 4', 5, 5', 6, 6') mittels Vertikalantrieben (7, 7', 8, 8') in einer Richtung quer zur Flächennormalen des Substrates (1) von einer Anlagestellung am Substrat (1) in eine Abstandsstellung zum Substrat (1) bringbar ist.

7. Vorrichtung nach einem der vorangehenden Ansprüche, **gekennzeichnet durch** Horizontalantriebe (15, 15') zur Horizontalverlagerung der Transportschlitten (13, 13', 14, 14') und Vertikalantriebe (7, 7', 8, 8') zur Verlagerung der Transportbalken (3, 3', 4, 4', 5, 5', 6, 6') zwischen einer Anlagestellung am Substrat (1) und einer Abstandsstellung zum Substrat (1), wobei die Antriebe (15, 15'; 7, 7', 8, 8') derart gesteuert werden, dass die Verlagerung der Transportbalken in den Bewegungsumkehrpunkten der Transportschlitten erfolgt oder während einer Bewegung aller Transportschlitten (13, 13', 14, 14') in der Transportrichtung (V).

8. Vorrichtung nach einem der vorangehenden Ansprüche, **dadurch gekennzeichnet, dass** der Reaktor (20) ein CVD-Reaktor ist.

9. Vorrichtung nach einem der vorangehenden Ansprüche, **dadurch gekennzeichnet, dass** mit dem Reaktor (20) Kohlenstoffnanopartikel, Graphen oder Kohlenstoffnanoröhrchen auf dem Substrat (1), insbesondere bei einer Temperatur > 1000°C, abgeschieden werden.

## Claims

1. A device for transporting a strip-shaped substrate (1) through a reactor (20), wherein the substrate (1) is held by transport elements (3, 3', 4, 4', 5, 5', 6, 6') that can be displaced in a transport direction (V) by a drive unit (15, 15'), wherein the transport means comprise first transport beams (3, 3', 4, 4') and second transport beams (5, 5', 6, 6') that alternately engage on the substrate (1), and wherein the transport beams, which respectively engage on the substrate (1), are moved in the transport direction (V) and the transport beams, which respectively do not engage on the substrate, are moved in a reverse direction (R) opposite to the transport direction (V), **characterized in that** the transport beams (3, 3', 4, 4', 5, 5', 6, 6') feature clamping flanks (9, 9', 10, 10', 11, 11', 12,12') for clamping the substrate (1) between two clamping flanks.

2. The device according to claim 1, **characterized in that** transport carriages (13, 13', 14, 14') are respectively arranged in pairs upstream and downstream of the reactor (20) referred to the transport direction (V).

3. The device according to one of the preceding claims, **characterized in that** the clamping flanks (9, 9', 10, 10', 11, 11', 12, 12') hold the edge (2, 2') of the substrate (1) in a clamping manner.

4. The device according to one of the preceding claims, **characterized in that** the transport carriages (13, 13', 14, 14') are arranged and connected to one another with transport beams (3, 3') to (6, 6') in such a way that during the motion phase, in which the transport carriages (13, 14) arranged on one side of the reactor (20) move towards one another, the transport carriages (13', 14') arranged on the other side of the reactor (20) move away from one another, wherein the first transport beams (3, 3', 4, 4') are shorter than the second transport beams (5, 5', 6, 6').

5. The device according to one of the preceding claims, **characterized in that** the transport beams comprise lower transport beams (4, 4', 6, 6') and upper transport beams (3, 3', 5, 5'), wherein the substrate (1) is held by the transport beams, which are respectively displaced in the transport direction (V), due to its position between two clamping surfaces (9, 9', 10, 10', 11, 11', 12, 12') of an upper and a lower transport beam.

6. The device according to one of the preceding claims, **characterized in that** the transport beams (3, 3', 4, 4', 5, 5', 6, 6') can be moved from a position, in which they contact the substrate (1), into a position, in which they are spaced apart from the substrate (1), in a direction extending transverse to the surface normal of the substrate (1) by means of vertical drives (7, 7', 8, 8').

7. The device according to one of the preceding claims, **characterized by** horizontal drives (15, 15') for horizontally displacing the transport carriages (13, 13', 14, 14') and vertical drives (7, 7', 8, 8') for displacing the transport beams (3, 3', 4, 4', 5, 5', 6, 6') between a position, in which they contact the substrate (1), and a position, in which they are spaced apart from the substrate (1), wherein the drives (15, 15'; 7, 7', 8, 8') are controlled in such a way that the displacement of the transport beams takes place in the motion reversal points of the transport carriages or during a motion of all transport carriages (13, 13', 14, 14') in the transport direction (V).

8. The device according to one of the preceding claims, **characterized in that** the reactor (20) is a CVD reactor.

9. The device according to one of the preceding claims, **characterized in that** carbon nanoparticles, graphenes or carbon nanotubes are deposited on the substrate (1) with the reactor (20), particularly at a temperature > 1000 °C.

## Revendications

1. Dispositif de transport d'un substrat (1) en forme de bande à travers un réacteur (20), le substrat (1) étant maintenu par des éléments de transport (3, 3', 4, 4', 5, 5', 6, 6') qui sont déplaçables dans un sens de transport (V) par une unité d'entraînement (15, 15'), les moyens de transport comportant des premières barres de transport (3, 3', 4, 4') et des deuxièmes barres de transport (5, 5', 6, 6') qui sont appliquées sur le substrat (1) de manière temporellement alternées, les barres de transport qui sont chacune appliquée sur le substrat (1) étant déplacées dans le sens de transport (V) et les barres de transport ne sont pas appliquées sur le substrat étant déplacées dans un sens inverse (R) opposé au sens de transport (V), **caractérisé en ce que** les barres de transport (3, 3', 4, 4', 5, 5', 6, 6') comportent des flancs de serrage (9, 9', 10, 10', 11, 11', 12, 12') pour maintenir le substrat (1) par serrage entre deux bords de serrage.

2. Dispositif selon la revendication 1, **caractérisé par** des chariots de transport (13, 13', 14, 14') disposés par paires respectivement en avant et en arrière du réacteur (20) dans le sens de transport (V).

3. Dispositif selon l'une des revendications précédentes, **caractérisé en ce que** les flancs de serrage (9, 9', 10, 10', 11, 11', 12, 12', 13, 13') maintiennent par serrage le bord (2, 2') du substrat (1).

4. Dispositif selon l'une des revendications précédentes, **caractérisé en ce que** les chariots de transport (13, 13', 14, 14') sont disposés et reliés entre eux par des barres de transport (3, 3') à (6, 6') de telle manière que, pendant une phase de déplacement dans laquelle les chariots de transport (13, 14) disposés d'un côté du réacteur (20), se rapprochent les uns des autres, et les chariots de transport (13', 14') disposés de l'autre côté du réacteur (20) s'écartent les uns des autres, les premières barres de transport (3, 3', 4, 4') étant plus courtes que les deuxièmes barres de transport (5, 5', 6, 6').

5. Dispositif selon l'une des revendications précédentes, **caractérisé en ce que** les barres de transport comportent des barres de transport inférieures (4, 4', 6, 6') et des barres de transport supérieures (3, 3', 5, 5'), le substrat (1) étant maintenu par les barres de transport, déplacées chacune dans le sens de transport (V), par le biais d'une couche intermédiaire entre deux surfaces de serrage (9, 9', 10, 10', 11, 11', 12, 12') d'une barre de transport supérieure et d'une barre de transport inférieure.

6. Dispositif selon l'une des revendications précédentes, **caractérisé en ce que** les barres de transport (3, 3', 4, 4', 5, 5', 6, 6') peuvent être amenée d'une position de butée au niveau du substrat (1) jusqu'à une position distante du substrat (1) dans une direction transversale à la normale de surface du substrat (1) au moyen d'entraînements verticaux (7, 7', 8, 8').

7. Dispositif selon l'une des revendications précédentes, **caractérisé par** des entraînements horizontaux (15, 15') destinés à déplacer horizontalement des chariots de transport (13, 13', 14, 14') et des entraînements verticaux (7, 7', 8, 8') destinés à déplacer les barres de transport (3, 3', 4, 4', 5, 5', 6, 6') entre une position de butée au niveau du substrat (1) et une position distante du substrat (1), les entraînements (15, 15'; 7, 7', 8, 8') étant commandés de telle sorte que le déplacement des barres de transport étant effectué dans les points d'inversion de mouvement des chariots de transport ou pendant un mouvement de tous les chariots de transport (13, 13', 14, 14') dans le sens de transport (V).

8. Dispositif selon l'une des revendications précédentes, **caractérisé en ce que** le réacteur (20) est un réacteur CVD.

9. Dispositif selon l'une des revendications précédentes, **caractérisé en ce que** des nanoparticules de carbone, du graphène ou des nanotubes de carbone sont déposés au moyen du réacteur (20) sur le substrat (1), en particulier à une température > 1000 °C.
